# EUROPEAN PATENT APPLICATION

(11) **EP 0 848 288 A1**
(43) Date of publication of application: **17.06.1998**
(21) Application number: 97309029.3
(22) Date of filing: 11.11.1997
(51) Int. Cl.: G03F 7/004

(54) **Resist materials**

(30) Priority: 16.12.1996 US 767493
(71) Applicant: LUCENT TECHNOLOGIES INC., Murray Hill, New Jersey 07974-0636 (US)
(72) Inventor: Houlihan, Francis Michael, Millington, New Jersey 07946 (US); Nalamasu, Omkaram, Basking Ridge, New Jersey 07920 (US)
(74) Representative: Johnston, Kenneth Graham

(57) **Abstract**

A lithographic process for device fabrication and an energy sensitive material for use in the lithographic process for device fabrication is disclosed. In the process, a layer of energy sensitive material is formed over the surface of a substrate. An image of a pattern is delineated into the energy sensitive material using radiation with a wavelength in the of 220 nm to 300 nm. The pattern is then developed. After the pattern is developed into the resist, it is transferred into the underlying substrate. The resist material contains a polymer with acetal or ketal acid sensitive moieties in combination with a photoacid generator that releases an acid with a pKₐ of less than two when exposed to radiation within the above described range.

## Description

### BACKGROUND OF THE INVENTION

### 1. Technical Field

This invention relates to lithographic processes, and, in particular, to energy sensitive resist materials used in lithographic processes involving device fabrication.

### 2. Art Background

Lithographic processes are typically employed in the manufacture of devices such as semiconductor devices. Among the lithographic processes that are available, photolithography is often utilized. Photolithographic processes have the advantage of being suitable for a blanket exposure technique. That is, a material that is sensitive to the exposing light is coated onto the substrate, e.g. silicon wafer, that is being processed to form a plurality of devices. The coating material, i.e., the resist, is then subjected to light that has been passed through a mask material so that the light reaching the resist corresponds to a desired pattern that is to be transferred into the underlying substrate. Since the exposure occurs simultaneously over an entire device or a number of devices being processed on a substrate, e.g., a silicon substrate, the procedure is considered a blanket exposure.

A blanket exposure procedure is advantageous because it is relatively fast compared to other methods such as the raster scan technique usually employed when the energy used to expose the resist is a beam of electrons. However, generally, resolution obtainable through a blanket exposure with ultraviolet or visible light is somewhat poorer than that achieved with other methods such as electron beam lithography.

Improved resolution with a blanket exposure is achievable by using deep ultraviolet light. One approach to a photoresist sensitive to deep ultraviolet radiation employs a compound that produces an acid moiety upon irradiation with such radiation together with a polymer that reacts with the generated acid. Typical acid generator/acid sensitive polymer combinations include an onium salt such as the photosensitive acid generator and a polymer such as poly(p-t-butoxycarbonyloxystyrene) as the polymer having a relative substituent. The acid labile substituent, t-butoxycarbonyl, is referred to as "t-boc" hereinafter.

As noted in Nalamasu, O., et al., "An Analysis of Process Issues with Chemically Amplified Positive Resists," Microelectronics Technology: Polymers for Advanced Imaging and Packaging, ACS Symposium Series No. 614: Chapter 1 (1995), the stability of the resist during the post exposure delay (PED), which is the time period between the cessation of the exposure step and the commencement of the post-exposure bake (PEB)) is critical because the post exposure bake catalyzes the reaction that introduces selectivity between the exposed portion and the unexposed portion of the resist material that is exploited in subsequent pattern development. If the photoacid is depleted or deactivated during the PED, the developed features are less likely to have the desired dimensions. Because effects such as the depletion or deactivation of the photoacid during PED have adverse processing consequences, these effects are referred to collectively as adverse PED effects.

Houlihan, F., et al., "Correlation of Strength of Photogenerated Acid with the Post-Exposure Delay Effect in Positive Tone Chemically Amplified Deep-UV Resists," Microelectronics Technology: Polymers for Advanced Imaging and Packaging, ACS Symposium Series No. 614: Chapter 6 (1995) (Houlihan et al. hereinafter), observe that PED is process-induced delay, and describe efforts to reduce the adverse PED effects that occur during the delay. These efforts include using protective overcoats and filtering impurities from the air (to avoid exposing the resist to compounds that could deplete or deactivate the photoacid in the resist), and annealing away free volume from the polymer.

Houlihan et al. observe that adverse PED effects can be reduced by using a photoacid generator (PAG) that has polarizable substituents at the 4 position of the aryl sulfonate moiety. Houlihan et al. also observed that, of the class of nitrobenzyl PAGs described therein, those PAGs that generate a weak acid moiety (when the photoacid is exposed to radiation) provide a greater resistance to adverse PED effects than do PAGs which generate a more acidic moiety when exposed to radiation. Houlihan et al. provides a hierarchy of acidic moieties based on the relative resistance to adverse PED effects that these moieties impart to resist materials having PAGs with these moieties. The reported hierarchy, in order of decreasing resistance to adverse PED effects that these moieties impart to the resist material is 4-OCH₃ > 4-NO₂ > 4-Cl >> 3-SO₃R >> 4-CH₃ ≥ 4-H > 2-CF₃ ≥ 3-CF₃ ≥ 4-CF₃ > 2,4-diF > 2-NO₂ > 3,5-diCF₃.

However, Houlihan also report that the clearing dose required for these resist materials (based upon a system in which the resist polymer is a t-boc polymer) formulated with PAGs having OCH₃, 4-NO₂, or 4-Cl moieties is quite high. Specifically, Houlihan et al. report that the clearing doses for a resist with the PAG that generated the most weakly acidic moiety (4-methoxybenzenesulfonate) was unacceptably high (162 mJ/cm²). Accordingly, although a substantial amount of effort has been expended to reduce the PED in a resist material, a universal scheme for reducing adverse PED effects in energy sensitive resist materials that have acceptable properties for use in processes for device fabrication has not been proposed.

### SUMMARY OF THE INVENTION

In the resist material of the present invention, an acid sensitive polymer combined with an acid generator with a weakly acidic moiety provides extremely good resistance to adverse PED effects. The acid sensitive polymer has an acid sensitive group with an activation energy that is sufficient so that a sufficient number of the acid sensitive groups will cleave from the polymer in the presence of the weak acid generated when the acid generator is exposed to radiation. The generated acid reacts with the acid sensitive polymer to provide the desired difference in aqueous base solubility between the unexposed region and the exposed region of the resist. Examples of acid sensitive groups with such an activation energy level include acetals and ketals. The acid sensitive polymer has the following structure incorporated into the polymer backbone: 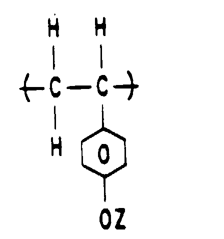 wherein Z denotes the acid sensitive acetal or ketal moiety. Examples of suitable acetal and ketal moieties have the following structure: 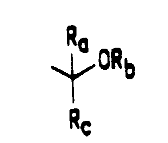 wherein Rₐ and R_{c} are selected from the group consisting of hydrogen, methyl, ethyl, t-butyl, and other lower alkyl moieties wherein the number of carbon atoms is five or less, and R_{b} is selected from the group consisting of methyl, ethyl, t-butyl, isopropyl and other lower alkyl moieties. In the acetal moieties, one of either Rₐ or R_{c} are hydrogen. In the ketal moieties, neither Rₐ nor R_{c} are hydrogen. Another example of suitable acetal and ketal moieties include dihydropyran derivatives having the general structure: 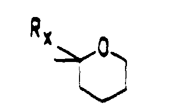 wherein Rₓ is H if the moiety is an acetal and Rₓ is a methyl, ethyl, t-butyl, or other lower alkyl moiety as previously described if the moiety is a ketal. Another illustrative ketal moiety is a derivative of dihydrofuran with the following structure: 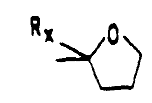 wherein Rₓ is a methyl, ethyl, t-butyl, or other lower alkyl moiety. It is advantageous if Z is an acetal moiety.

The acid sensitive polymer backbone contains the above-described moieties and at least one other moiety. It is advantageous if about 20 mole percent to about 50 mole percent of the moieties in the acid sensitive polymer backbone have the acid sensitive acetal or ketal groups pendant thereto. The moieties with the acid sensitive groups pendant thereto are referred to as the imaging moieties. Since the acid sensitive polymer is typically prepared by reacting a hydroxystyrene polymer with a vinyl ether to attach the acid labile acetal or ketal groups to the polymer, the other moiety in the acid sensitive polymer backbone is typically hydroxystyrene. Such polymers in combination with a suitable PAG have sensitivities on the order of about 20 mJoules/cm² to about 50 mJoules/cm² with a 248 nm excimer laser light source, exhibit resolutions better than 0.5 micrometers, have contrast in excess of about four and are sensitive to deep ultraviolet (UV) light, e.g., light in the wavelength range of 220 nm to 300 nm.

When exposed to radiation, the PAG generates a sulfonic acid with a pKₐ of about -2 or less. Such a PAG has the following structure: 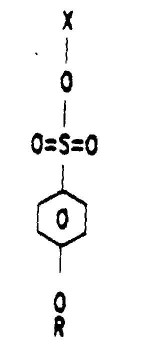 Examples of suitable R moieties include lower alkyl moieties (e.g., methyl, ethyl, and propyl). An example of a suitable PAG is 2-trifluoromethyl-6-nitrobenzyl 4-methoxybenzenesulfonate. In the above described structure, the X moiety is a chromophore that will release the aryl sulfonate moiety when exposed to radiation in the appropriate wavelength range.

Resist materials with the above described polymers have the requisite sensitivity and demonstrate the desired resolution when the wavelength of the exposing radiation is in the range of about 220 nm to about 300 nm. The acidic moieties will be released from the PAG when exposed to radiation with a wavelength within this range. However, the PAGs specified herein will release acidic moieties when exposed to radiation in the range of about 190 nm to about 300 nm, making them compatible for use With resist polymers that have the desired resolution and sensitivity when exposed to radiation with a wavelength within this range. The PAGs specified herein are also thermally stable at temperature up to at least 100°C. In the context of PAGs thermal stability refers to the temperatures which the PAGs can withstand intact in the resist matrix. At some threshold temperature, the PAG will generate acid without being exposed to radiation. Because the resist materials of the present invention are typically baked at elevated temperatures, it is advantageous if the PAGs are thermally stable at such baking temperatures.

Examples of suitable chromophores include nitrobenzyl moieties with the following structure: 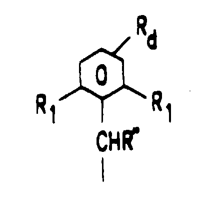 where R_{d} is not critical provided R_{d} is not acid and does not absorb ultraviolet light to the point where such absorption substantially degrades sensitivity. Exemplary substituents for R_{d} are H, lower alkyl and halogen. R₁ is a substituent with that has an appropriate combination of steric and electron withdrawing characteristics. Exemplary substituents for R₁ are NO₂, hydrogen, perfluorinated alkyls, lower alkyls (up to 6 carbon atoms), and halogens. At least one of R₁ is -NO₂. R" is either hydrogen, CH₃, 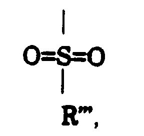 CN, or CO₂R‴, where R‴ is a lower alkyl group.

Other examples of suitable chromophores include iodoaryl moieties with the following general structure: 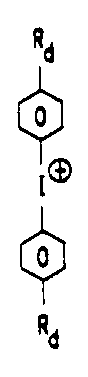 where the R_{d} groups are the same or different and R_{d} is as previously described. Exemplary substituants for R_{d} are H, lower alkyl, halogen, and alkoxy. The above described cation chromophore forms a salt with the previously described anionic aryl sulfonate moieties.

Another example of a suitable chromophore includes the anion of an onium salt with the following general structure: 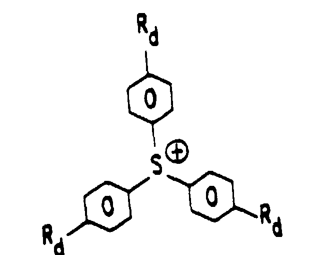 where the R_{d} groups are the same or different and R_{d} is as previously defined. Exemplary substituents for R_{d} are H, lower alkyl, halogen, and alkoxy.

Another example of a suitable chromophore is the following imide chromophore with the structure: 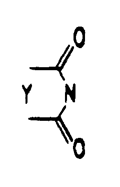 wherein Y is either ortho-benzene or 1,3 napthene. PAGs with this chromophore are described in Ito, H., et al., "Influence of acid generator structure on T-top formation in high temperature bake processes for environmental stabilization,"SPIE Vol. 2438, pp. 53-60 (1995), which is hereby incorporated by reference.

The above described chromophores are all selected because PAGs with these chromophores are thermally stable (i.e. only a lithographically insignificant number of these chromophores release the aryl sulfonate moiety attached thereto when subjected to temperatures to which resist materials are typically exposed prior to the exposure step in lithographic processes for device fabrication).

In the process of the present invention, the polymer is combined with a nitrogen-containing base that provides stability and improves the delineation of the pattern. The nitrogen-containing base also enhances the adhesion between the resist material and the underlying substrate. These materials are described in European Application No. 93301340.1 (Publication No. 0 558 280 A1) to Murata, M. et al., which is hereby incorporated by reference. It is advantageous if the nitrogen-containing base is triphenylimidazole (TPI) and its derivatives with the following structure: 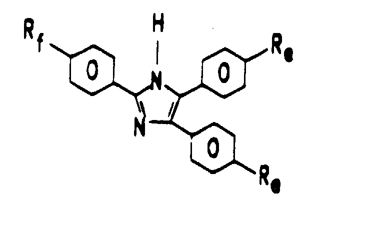 wherein Rₑ is either hydrogen, methoxy, or lower alkyl and R_{f} is either methoxy, NO₂, or lower alkyl. Oxydianiline and its derivatives are further examples of suitable nitrogen-containing bases, but are less preferable based on the toxicology of these compounds.

In the process of the present invention the resist material contains about 0.5 weight percent to about ten weight percent of PAG based on the weight of the polymer component. The amount of base is about 0.05 weight percent to about one weight percent of the polymer component.

### DETAILED DESCRIPTION

As previously described, the solubility of the resist composition of the present invention is dependent on the number of acid sensitive moieties pendant to the polymer material. The greater the number of acid sensitive groups that are pendant to the polymer, the more insoluble the resist material is rendered in aqueous base solution. The acid sensitive polymer has the following structure incorporated into the polymer backbone: 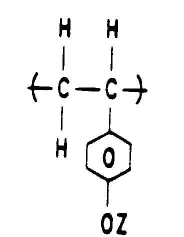 wherein Z denotes an acid sensitive acetal or ketal moiety. Examples of suitable acetal and ketal moieties have the following structure: 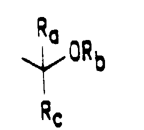 wherein Rₐ and R_{c} are selected from the group consisting of hydrogen, methyl, ethyl, t-butyl, and other lower alkyl moieties wherein the number of carbon atoms is five or less, and R_{b} is selected from the group consisting of methyl, ethyl, t-butyl, and other lower alkyl moieties. In the acetal moieties, one of either Rₐ or R_{c} are hydrogen. In the ketal moieties, neither Rₐ nor R_{c} are hydrogen. Other examples of suitable acetal and ketal moieties include the previously described derivatives of dihydropyran and dihydrofuran.

The acid sensitive polymer backbone contains other moieties. The moieties incorporated into the polymer backbone are referred to as repeat units herein. It advantageous if about 20 mole percent to about 50 mole percent of the repeat units that make up the polymer have the above-described structure. For convenience, the above-described repeat unit is referred to herein as the imaging moiety. These moieties, and resist polymers with these moieties, are described in Mertesdorf, C., et al., "Structural Design of Ketal and Acetal Blocking Groups in 2-Component Chemically Amplified Positive DUV-Resists, SPIE, Vol. 2438 pp. 84-98 (1996) which is hereby incorporated by reference.

Mertesdorf et al. describes one method for forming the above.described polymers in which a hydroxystyrene polymer is subjected to an acid catalyzed reaction with enol ethers to form the above described acetal and ketal protected polymers. The other moiety in the backbone of the polymer prepared by this method is a hydroxystyrene moiety. In this embodiment, about 50 mole percent to about 80 mole percent of the repeat units that make up the polymer are hydroxystyrene moieties.

In an alternative embodiment, the previously described acid sensitive polymer is crosslinked. Crosslinking provides an acid sensitive polymer with increased thermal stability. Crooolinking is obtained by incorporating acetal or ketal moieties into the polymer which cross-link with other acetal or ketal moieties. Crosslinked polymers with acid labile acetal or ketal moieties, and methods for preparing such polymers, are described in Schacht, H., et al., "Acid Labile Crosslinked Units: A New Concept for Deep-UV Photoresists," Journal of Photopolymer Science and Technology, Vol. 9(4), pp. 573-586 (1996), which is hereby incorporated by reference. As described in Schacht et al., such polymers are formed by reacting a copolymer of 4-hydroxystyrene and 4-vinylcyclohexanol with a vinyl ether after which some of the hydroxy functionality on both the hydroxystyrene and vinyl cyclohexanol moieties is replaced by acetal or ketal moieties.

Whether the cross-linking moiety is an acetal or a ketal depends upon the specific vinyl ether selected. Examples of suitable vinyl ethers include ethylvinyl ether, t-butylvinyl ether and dihydropyran. In the embodiment of the present invention in which the acetal or ketal cross-linking moieties are present in the polymer, the amount of these cross-linking moieties incorporated into the polymer backbone is about 0.25 mole percent to about 5 mole percent of the repeat units that make up the polymer backbone. Since the cross-link is formed between the acid sensitive acetal or ketal moieties, the cross-linking is reversed when the resist material is exposed to radiation.

The polymer produced should preferably have a glass transition temperature, T_{g}, that is higher than 80°C, preferably higher than 100°C. If the T_{g}, is substantially lower than the given limit, there is a tendency for the resist to flow during subsequent processing, thus degrading image quality. Generally, with monomers such as substituted styrenes, suitable T_{g}'s are obtained.

The resist material of the present invention is formed by combining the above-described polymer with the previously described PAG and nitrogen-containing base in a suitable solvent therefore. Such solvents are well known to one skilled in the art. The resist material contains about 5 weight percent to about 30 weight percent polymer relative to the amount of solvent combined with the resist material. The amount of PAG in the resist material is about 0.5 weight percent to about 10 weight percent relative to the amount of polymer in the resist material. The amount of nitrogen-containing base in the resist material is about 0.05 weight percent to about 1 weight percent based on the amount of polymer in the resist material.

The resulting resist should form a continuous pinhole-free coating on the substrate to be treated. For example, in the case of a silicon-based substrate, such as a processed silicon device wafer, the subject resists form excellent coatings. Typically, the thickness of the polymer coating utilized is in the range of about 0.2 µm to about 2 µm, preferably about 0.3 µm to about 1 µm. Thinner coatings are difficult to maintain pinhole free. Additionally, in thicker coatings the resolution is generally inferior since the delineation of narrow features results in the production of narrow columns in the developed pattern that tend to deform. Thicker layers also lead to greater absorption with a resulting degradation in image quality.

An appropriate optical density in the wavelength range to be used for exposure significantly enhances resist quality. Too low an optical density results in inefficient absorption of the exposing radiation and in unnecessarily long exposure times. Too high an optical density does not permit sufficient light to reach the regions of the film furthest removed from its ambient/polymer film interface. This incomplete exposure tends to degrade resist image quality. In general, it is desirable to employ an optical density that is preferably less than 0.5 for at least 30 percent of the actinic radiation that reaches the polymer at the exposure wavelength.

The optical density depends on the concentration of the absorbing species in both the polymer and the acid generator. Thus, once a suitable thickness for the resist material is chosen, the resist composition is adjusted to provide the desired optical density. For thicknesses as previously discussed in connection with film continuity, if the desired optical density is maintained, useful results are attained.

The resolution and sensitivity obtained depend on the average molecular weight (defined by Billmeyer, *Textbook of Polymer Science,* p. 6, 1971, J. Wiley and Sons) of the polymer, the distribution of the molecular weight, and the relative proportion of the imaging moiety in the polymer in relative to the other moieties in the monomer. For relatively high sensitivities, it is generally desirable to employ polymers with molecular weights greater than 1,000, preferably greater than 2,500 and dispersivities below 10, preferably below 4. (Dispersivity as defined in Billmeyer, supra, p. 6.) Molecular weights greater than 5 x 10⁶ and dispersivities larger than 10 are not desirable because polymer solubility and resist contrast will be reduced, respectively. The molecular weight of the polymer is determined by the polymerization reaction conditions such as initiator, monomer concentration, and temperature. These parameters are interrelated and a control sample is utilized to determined the specific conditions necessary to yield the desired molecular weight.

In the process of the present invention, the above-described resist material is applied onto a substrate, typically a silicon wafer. The above-described resist is combined with a suitable solvent, such as propylene glycol methyl ether acetate, and applied onto the substrate using a conventional technique such as spin coating. An image of a pattern is delineated into the resist material via a patternwise exposure. The wavelength of the exposing radiation is in the range of about 190 nm to about 300 nm. It is advantageous if the wavelength is in the range of about 220 nm to about 300 nm. The radiation dose is in the range of about 20 mJ/cm² to about 50 mJ/cm². Prior to the exposing step, the resist is baked at a temperature in the range of about 90°C to about 130°C.

After the exposure step, the resist is baked to accelerate the rate at which the acid sensitive moieties are removed from the polymer. In the embodiment of the present invention wherein the acid sensitive moiety is t-butyl vinyl ether, a post exposure step is not required because these moieties cleave from the polymer at an acceptable rate at room temperature in the presence of acid. In the embodiment of the present invention wherein the acid sensitive acetal and ketal moieties have an activation energy less than that of the t-butyl vinyl ether moiety, a post exposure bake step is contemplated as useful to accelerate the removal of these acid sensitive moieties (removal is typically referred to as deprotection). The rate of deprotection increases with increasing temperature. If a post exposure bake step is required, temperatures in the range of about 90°C to about 130° for at least about 30 seconds are contemplated as suitable. After the post exposure bake, the pattern is developed using a conventional aqueous base developer such as tetramethylammonium hydroxide. After development, the pattern is transferred into the underlying substrate using a conventional plasma etch expedient.

The following examples are provided to further illustrate certain embodiments of this invention.

### Example 1

2-Trifluoromethyl-6-nitrobenzyl 4-methoxybenzenesulfonate PAG was prepared using dicylohexylamine. 2.Trifluoromethyl-6-nitrobenzyl alcohol (40.00 g, 0.1809 moles) and 4-methoxybenzenesulfonyl chloride (37.38 g, 0.1809 moles) were placed in a 1 liter (L) flask equipped with a reflux column with an attached nitrogen/vacuum inlet and a dropping funnel. The flask containing the reagents was evacuated and purged with dry nitrogen two times. Dry acetone (350 mL) was then introduced into the reaction flask and the reagents allowed to dissolve with stirring at room temperature. The reaction mixture was cooled to 0°C and dicyclohexylamine (36.04 mL, 0.1809 moles) in 20 mL of acetone was introduced dropwise. No noticeable heat evolution was seen during this step in which the amine was added over a period of 10 minutes.

The reaction mixture was then allowed to return to room temperature and left stirring for 24 h. After this time the reaction was mostly complete (∼70%). The reaction mixture was filtered and the precipitated dicyclohexyl ammonium hydrochloride was washed with 100 mL of acetone. The filtrate and washings were combined and the total volume of solvent was reduced to 250 mL under reduced pressure at 30°C. This residue was filtered to remove any residual dicyclohexylammonium hydrochloride. To this filtrate was added 650 mL of hexane. This mixture was allowed to slowly crystallize at 0°C for several hours. After repeating this recrystallization procedure once again, the material was filtered and dried under vacuum for several hours. The material was then recrystallized twice from 600 mL of boiling hot isopropanol. The yield of pure product after drying under vacuum was 39 g (54% yield).

### Example 2

2-Trifluoromethyl-6-nitrobenzyl 4-methoxybenzenesulfonate was synthesized using tetramethylammonium hydroxide (TMAH). 2-Trifluoromethyl-nitrobenzyl alcohol (20 g, 90.4 mmoles) and 4-methoxybenzenesulfonyl chloride (18.68 g, 90.4 mmoles) were stirred with 20 mL of toluene until all the 4.methoxybenzenesulfonylchoride had dissolved. The resultant solution, which contained a suspension of the partially dissolved alcohol, was cooled with stirring to 0°C. To this cooled suspension was added, while maintaining efficient rapid stirring, an ice cold solution of tetramethylammonium pentahydrate (32.78 g, 180.1 mmoles) dissolved in 24 mL of distilled water. The rapid addition of this reagent caused the reaction temperature to increase to ∼30°C.

After a few minutes of stirring the product precipitated out of solution and formed large clumps. Monitoring of the reaction indicated that the reaction had almost reached completion after 15 minutes. After 1 hour of stirring, 100 mL of ethyl acetate was added to the reaction mixture and the mixture stirred for a few minutes until the product clumps had broken up. The reaction mixture was transferred to a separatory funnel and was diluted with 270 mL of ethyl acetate forming a clear two phase system after shaking. The bottom aqueous layer was discarded and the top organic layer washed with 3 x 50 mL of distilled water to remove excess TMAH. The separated organic layer was evaporated under vacuum (20 mm Hg) at 30°C to remove the solvents and any remaining water. In this way 35 g of crude product was recovered this product was recrystallized three times in 350 mL of boiling ethanol to give 30.2 g of purified product (86 % yield).

### Example 3

2,6-Nitrobenzyl 4-methoxybenzenesulfonate was synthesized using the procedure described in the previous example two. 2,6-Dinitrobenzyl alcohol (5g, 2.52 mmoles) was combined with an equimolar amount of 4-methoxybenzenesulfonyl chloride, 18.4 mL of a 25 % TMAH aqueous solution and 5 mL of toluene. The product was recrystallized from 250 mL of hot ethanol to give 7.4 g (80 % yield) of 2,6-dinitrobenzyl 4-methoxybenzenesulfonate. Consequently, the procedure described in example 2 is useful for functionalizing other 2-nitrobenzyl chromophores with alkoxybenzenzsulfonate.

### Example 4

Bis(4-t-butylphenyl)iododium 4-alkoxybenzenesulfonate and tris(4-t-butylphenyl)sulfonium 4-alkoxybenzenesulfonate were synthesized using the following procedure. Bis(t-butylphenyl)iodonium chloride was synthesized by mixing acetic anhydride (120 mL) with sulfuric acid (84mL) by slowly adding the sulfuric acid to the acidic anhydride while cooling the solution with an ice bath to maintain the temperature below 20°C. The resulting mixture was added slowly, under nitrogen using a dropping funnel, to a mechanically stirred suspension of potassium iodate (120 g) in a mixture of acetic anhydride (120 mL) and t-butylbenzene (161 mL). The suspension was maintained at a temperature in the range of -5°C to 5°C by using a cooling bath. The mixture was stirred vigorously to avoid the formation of a heterogeneous mixture which has the potential to combust. The temperature was maintained in the specified range for at least a further half-hour to ensure that the exothermic part of the reaction was complete.

After the exothermic reaction was complete, the temperature of the mixture was allowed to return to room temperature. The mixture was stirred for a further 48 hours. The reaction was quenched while being stirred by the slow addition of distilled water (200 mL) while maintaining the temperature of the mixture at about 0°C with a cooling bath. After the exotherm of the quenching reaction is past, the reaction mixture is extracted twice with methylene chloride (100 mL). The organic layer was washed with distilled water and dried over anhydrous magnesium sulfate. After drying, the solution was filtered and stripped of solvents under reduced pressure to give about 220 g of crude bis(t-butylphenyl)iodonium hydrogen sulfate. This material was dissolved in methanol (300mL) to which was added with stirring a solution of ammonium chloride (72 g) in water (100 mL). The mixture was stirred overnight and then stripped of methanol under reduced pressure.

The residue was then extracted with twice with methylene chloride (100 mL) and the combined organic extracts were dried over anhydrous magnesium sulfate. After drying and filtration, this organic layer was precipitated into hexane (6 L). The precipitate was filtered, washed with hexane, and air dried. Bis(t-butylphenyl)iodonium chloride was recovered (150 g; 67% yield).

### Example 5

Bis(t-butylphenyl) iodonium 4-methoxybenzenesulfonate was prepared by the following procedure. 4-Methoxybenzenesulfonyl chloride (76g) was hydrolyzed by stirring it with distilled water (200 mL) while heating the mixture to a temperature in the range of 80°C to 100°C. The hydrolysis took about half an hour and was observed to complete when the insoluble sulfonyl chloride was gone. The water and most of HCl was removed by heating to 60°C under reduced pressure. Complete removal of HCl required the application of high vacuum (i.e. greater than 10 torr) while heating in the range of 600C to 70°C. A silver nitrate solution was used to monitor chloride removal. The temperature of the crude acid was maintained below 100°C. Crude 4.methoxybenzenesulfonic acid hydrate was recovered (8,5 g; about 100% yield).

Silver carbonate (85g) was added slowly added to a solution of the crude methoxybenzenesulfonic acid hydrate redissolved into water (1000 mL) with stirring.. A clear aqueous solution of the silver salt was obtained which was filtered to remove small amounts of unreacted silver carbonate. A portion of the resulting silver 4-methoxybenzenesulfonate (102.7 g) was combined with 1000 mL of distilled water. This solution was added with vigorous stirring to a solution of bis(t-butylphenyl)iodonium chloride (150 g) dissolved in methylene chloride (1000 mL). The solution was stirred vigorously for 24 h. The reaction mixture was then filtered.

The organic layer was separated off, the aqueous layer extracted with methylene chloride (100 mL) and the combined organic extracts dried over anhydrous magnesium sulfate. The dried solution of crude product was filtered and then stripped of most of the solvent (except about 200 mL) under reduced pressure. This solution was recrystallized by adding about 800 mL of ether thereto. The recrystallization was repeated twice. The final recrystallized material was dried under vacuum overnight to give white crystals (135 g; 67 percent yield).

### Example 6

Bis(t-butylphenyl) iodonium 4-methoxybenzenesulfonate was prepared by the following procedure. 4-Methoxybenzenesulfonyl chloride (76g) was hydrolyzed by stirring it with distilled water (200 mL) while heating the mixture to a temperature in the range of 80°C to 100°C. The hydrolysis took about half an hour and was observed to complete when the insoluble sulfonyl chloride was gone. The water and most of HCl was removed by heating to 60°C under reduced pressure. Complete removal of HCl required the application of high vacuum (i.e. greater than 10 torr) while heating in the range of 60°C to 70°C. A silver nitrate solution was used to monitor chloride removal. The temperature of the crude acid was maintained below 100°C. Crude 4-methoxybenzenesulfonic acid hydrate was recovered (8.5 g; about 100% yield).

Silver carbonate (85g) was added slowly added to a solution of the crude methoxybenzenesulfonic acid hydrate redissolved into water (1000 mL) with A clear aqueous solution of the silver salt was obtained which was filtered to remove small amounts of unreacted silver carbonate. A portion of the resulting silver 4-methoxybenzenesulfonate (102.7 g) was combined with 1000 mL of distilled water. This solution was added with vigorous stirring to a solution of bis(t-butylphenyl)iodonium chloride (150 g) dissolved in methylene chloride (1000 mL). The solution was stirred vigorously for 24 h. The reaction mixture was then filtered.

The organic layer was separated off, the aqueous layer extracted with methylene chloride (100 mL) and the combined organic extracts dried over anhydrous magnesium sulfate. The dried solution of crude product was filtered and then stripped of most of the solvent (except about 200 mL) under reduced pressure. This solution was stallized by adding about 800 mL of ether thereto. The recrystallization was repeated twice. The final recrystalllized material was dried under vacuum overnight to give white crystals of bis(t-butylphenyl)iodonium 4-methoxybenzenesulfonate (135 g; 67 percent yield). Recrystallization of product in the filtrate would have increased the yield.

Aluminum chloride (38 g 0.33 moles) was added slowly under nitrogen to a cooled solution (maintained at 10°C) of 0.5 moles of t-butylbenzene (67 g, 0.5 mole) in 200 mL of carbon disulfide. A mechanical stirrer was used to provide smooth mixing during the addition. To this stirred slurry, maintained at 10°C with cooling, was added thionyl chloride (39.75 g, 0.33 mole). The reaction mixture was stirred overnight at room temperature. After this time, the mixture was poured slowly into 500 g of ice containing 50 mL of concentrated HCl. The resulting white mass was extracted into methylene chloride, washed with water and dried with magnesium sulfate. After filtration the solvent and residual t-butyl benzene were removed under vacuum and the product recrystallized from hexane. In this way 10.0 g (10% yield) of 4-t-butylphenyl sulfoxide was recovered.

A 2M solution of 4-t-butylphenylmagnesium bromide (44.8 mL) in ether was stripped of ether under vacuum. To the residue under argon was added anhydrous toluene (34 mL) under argon. To this solution at 85°C was added 4-t-butylphenylsulfoxide (6.5 g, 0.02 mole) in solution in 70 mL of anhydrous toluene. The reaction was heated at reflux for 48 hours. The reaction mixture was cooled to 0°C and concentrated HCl (11 mL) in distilled water (20 mL) were added. The reaction mixture was extracted with chloroform and washed with distilled water. The organic layer was stripped of solvent and redissolved into ether (50 mL) to which 6% HCl (60 mL) was added. The precipitated salt was allowed to stir overnight. to yield 7.4 g (80% yield) of tris(4-t-butylphenyl)sulfonium chloride.

Tris(4-t-butylphenyl)sulfonium chloride (2.9 g, 0.0062 mole) was dissolved in methylene chloride (20 mL) to which was added an equimolar quantity of silver 4-methoxybenzenesulfonate (1.83 g) dissolved in 12 mL of distilled water (prepared as described in the previous example. After stirring overnight at room temperature the reaction mixture was filtered. The organic layer was separated, washed with distilled water, and dried over anhydrous magnesium sulfate. After filtration and removal of the solvent, the crude product was recrystallized from methylene chloride/ether to give 3.2 g of tris(4.t.butylphenyl)sulfonium 4-methoxybenzenesulfonate (95 % yield).

### Example 7

Polyhydroxystyrene monomer (VP-8000 from the Nisso Corp.) with 32% (mole or weight) protection with t-butyl vinyl ether (3.5 g), which was prepared as described in Mertesdorf, C., et al., "Structural Design of Ketal and Acetal Blocking Groups in 2-Component Chemically Amplified Positive DUV-Resists, SPIE, Vol. 2438 pp. 84-98 (1997), was dissolved into 20 mL propylene glycol methyl ether acetate (obtained from Aldrich Chemicals).

Five resist formulations were prepared. Each formulation contained the above-described monomer solution and one each of the following PAGs: 2,6-dinitrobenzyl 4-methoxybenzenesulfonate; tris(4-t-butylphenyl)sulfonium 4-methoxybenzenesulfonate; and bis(4-t-butylphenyl)iodonium 4-methoxybenzenesulfonate. Each formulation contained 0.925 g of the PAG (2.5 % by weight) and 0.00925 g of triphenylimidazole (TPI) (Aldrich Chemicals). Two resist formulations were prepared that contained a 2-trifluoromethyl-6-nitrobenzyl 4-methoxybenzenesulfonate PAG, which had a lower absorbency and quantum yield than the other PAG's. The first of these formulations contained 2.5 % by weight of the PAG and 0.00925 g of the TPI. The second resist formulation contained 5% by weight of the PAG 0.0185 g TPI in order to get comparable acid formation in the resist matrix. After complete dissolution, the solutions were filtered through a series of 1.0 µm, 0.5 µm, and 0.2 µm Teflon filters (Millipore Inc.). For convenience herein the formulations are identified by the quantity and type of PAG contained therein in the following manner.

**TABLE 1**

| **PAG (type and amount)** | **Number Designation of Associated Resist Formulation** |
|---|---|
| 2,6-dinitrobenzyl 4-methoxybenzenesulfonate (2.5 wt.%) | 1 |
| tris(4-t-butylphenyl)sulfonium 4-methoxybenzenesulfonate (2.5 wt.%) | 2 |
| bis(4-t-butylphenyl)iodonium 4-methoxybenzenesulfonate (2.5 wt.%) | 3 |
| 2-trifluoromethyl-6-nitrobenzyl 4-methoxybenzenesulfonate (2.5 wt.%) | 4 |
| 2-trifluoromethyl-6-nitrobenzyl 4-methoxybenzenesulfonate (5 wt.%) | 5 |

The wafers were coated with resist on a Machine Technology Incorporated (MTI) model Flexilab track and baked at 130°C for 90 seconds. The spin speed was in the range of 3000-3900 rpm and the nominal thicknesses of the resulting films were in the range of 0.71 µm to 0.76 µm. The resist thickness was measured by a Nanospec AFT thickness gauge using a refractive index of 1.56. Exposures were carried out on a GCA XLS KrF excimer laser stepper with a 0.53 NA lens obtained from GCA of Tewksbury, Mass. After exposure, PEB was performed at 115°C for 90 seconds. The wafers were developed with a 10 second spray and a 55 second puddle with OPD-4262 (0.262 N tetramethyl ammonium hydroxide) (OPD is Olin Microelectronics Materials, Inc., of East Providence, Rhode island) on an MTI track. The linewidths were measured on a Hitachi S-600 CD-SEM and cross section profiles were obtained by a JEOL 6400 F SEM.

Most of the formulations at 2.5% PAG loading had excellent post exposure time delay stability up to at least 8 hours with resolution of 0.25 micron dense lines showing straight wall profiles with no T-topping or line thinning at the same exposure dose. Isolated lines are similarly resistant to time delay showing no significant slimming after 4 hours at the same exposure dose. The only exception was the resist formulation with 2.5 % 2-trifluoromethyl-6-nitrobenzyl 4-methoxybenzenesulfonate which was unable to resolve 0.25 micron lines and spaces but gave a minimum resolution of 0.30 micron lines and spaces with delay stability of 4 hours. However, by increasing the loading of this low absorbance, low quantum yield PAG to 5%, resolution of 0.25 micron lines and spaces was achieved with delay stability up to 8 hours. The resolution dose for 0.25 microns lines and spaces were as follows: 2-trifluoromethyl-6-nitrobenzyl 4-methoxybenzenesulfonate (26.5 mJ/cm² and 19.5 mJ/cm2 for 5 and 2.5 % loadings respectively); 2,6-dinitrobenzyl 4-methoxybenzenesulfonate (34 mJ/cm² 2.5 %); tris(4-t-butylphenyl)sulfonium or bis(4-t-butylphenyl)iodonium 4-methoxybenzenesulfonates (∼7 mJ/cm² ). The depth of focus for these resists at 0.3 microns ranged from 1 to 1.3 microns. The specific results obtained are summarized in the following table:

**TABLE 2**

| **Resist Formulation (Table 1)** | **Time for onset of PED effect (hr)** | **Feature Size Resolution** | **Depth of Focus**^{**2**} |
|---|---|---|---|
| 1 | 8¹ | 0.23 µm | 1 µm |
| 2 | 8¹ | 0.23 µm | 1 µm |
| 3 | 8¹ | 0.23 µm | 1 µm |
| 4 | 4¹ | 0.25 µm | 1.3 µm |
| 5 | 8¹ | 0.25 µm | 1.3 µm |

| | | | |
|---|---|---|---|
| ¹For both 0.25 µm and 0.3 µm features. | | | |
| ²For 0.3 µm features | | | |

Formulation 5 in the above table had a resolution dose of 23 mJ/cm² for 0.25 µm features. Formulation 4 (which was the same formulation as formulation 5 except that the concentration of the PAG and the TPI in formulation 4 (2.5 % and 0.25 %, respectively) was one-half of the concentration of the PAG and the TPI in formulation 5. Formulation 4 had a lower resolution dose (17 mJ/cm²) than formulation 5. However, formulation 4 had a 50 percent lower time delay latitude than formulation 5.

Formulation 1 had a higher resolution dose (31 mJ/cm²) than formulation 4 (17 mJ/cm²) but the time delay latitude for formulation 1 was twice the time delay latitude for formulation four. The resolution dose is the dose required to resolve features of the desired size. The resolution dose for sub-micron sized features is typically about three times the clearing dose for a large area (e.g. an area with a dimension greater than 5 µm) of resist. The resolution dose of formulation 3 was 7 mJ/cm². Formulation 3 exhibited a time delay latitude that was twice that of formulation 4, which had the same loading (2.5 wt. %) of the 2.trifluoromethyl-6-nitrobenzyl 4-methoxybenzenesulfonate.

## Claims

1. A process for device fabrication comprising:
forming a layer of an energy sensitive material onto a substrate;
delineating an image of a pattern into the energy sensitive resist material by a patternwise exposure to radiation, wherein the wavelength of the exposing radiation is within the range of about 220 nm to about 300 nm:
developing the image into a pattern; and
transferring the pattern into the underlying substrate; wherein the energy sensitive material comprises an acid sensitive polymer that has incorporated into the polymer backbone moieties with the following formulation: 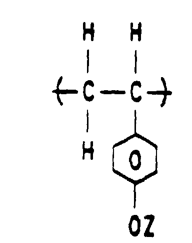 wherein Z is an acid labile acetal or ketal moiety;
an energy sensitive compound that generates a sulfonic acid with a pKₐ of about -2 or less wherein the energy sensitive compound has the following structure 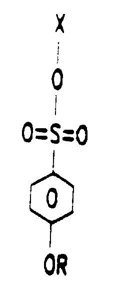 wherein R is a lower alkyl moiety selected from the group consisting of methyl, ethyl, and propyl and X is a chromophore that cleaves with the aryl sulfonate moiety when exposed to radiation; and
a nitrogen containing base.

2. The process of claim 1 wherein the acid sensitive polymer contains at least about 20 mole percent to about 50 mole percent of the monomer with the acid labile group pendant thereto.

3. The process of claim 2 wherein the acid sensitive polymer has hydroxystyrene moieties incorporated into the polymer backbone.

4. The process of claim 3 wherein the acid sensitive polymer has a crosslinking moiety incorporated into the polymer backbone and wherein the crosslinking moiety is selected from acetal moieties and ketal moieties.

5. The process of claim 4 wherein the amount of crosslinking moieties in the polymer is less than about five mole percent of the total number of moieties in the polymer backbone.

6. The process of claim 2 wherein the aryl sulfonate moiety in the energy sensitive compound cleaves with the chromophore when exposed to radiation at a wavelength in the range of about 190 nm to about 300 nm.

7. The process of claim 6 wherein the energy sensitive compound has a sensitivity in the range of about 20 mJ/cm² to about 50 mJ/cm² when the exposing radiation has a wavelength of about 248 nm.

8. The process of claim 6 wherein the chromophore has the following structure: 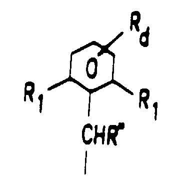 where R_{d} is not acid and does not substantially absorb ultraviolet light; and R" is a substituent with that has an appropriate combination of steric and electron withdrawing characteristics.

9. The process of claim 8 wherein R₁ is selected from the group consisting of NO₂, hydrogen, perfluorinated alkyls, lower alkyls (up to 6 carbon atoms), and halogens, and R" is selected from the group consisting of H, CH₃, CN, CO₂R‴, and 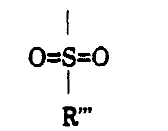 wherein R"' is a lower alkyl group and wherein at least one of R₁ is -NO₂.

10. The process of claim 6 wherein the chromophore has the following structure: 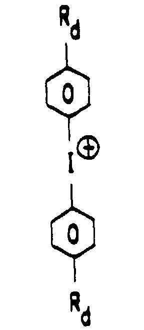 where R_{d} not an acid and does not substantially absorb ultraviolet light.

11. The process of claim 6 wherein the chromophore has the following structure: 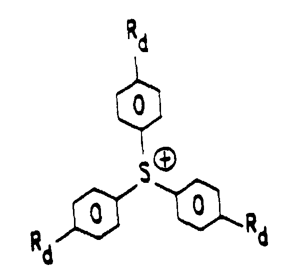 where R_{d} is not an acid and does not substantially absorb ultraviolet light.

12. The process of claim 6 wherein the chromophore is an imide chromophore with the structure: 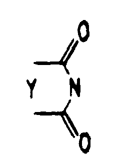 wherein Y is either ortho-benzene or 1,3 napthene.

13. The process of claim 1 wherein the nitrogen-containing base is a triphenylimidazole derivative with the following structure: 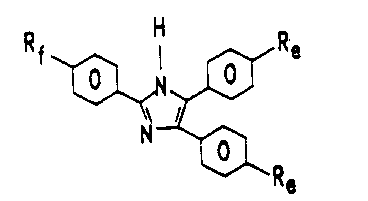 wherein Rₑ is selected from the group consisting of hydrogen, methoxy, and lower alkyl and R_{f} is selected from the group consisting of methoxy, NO₂, and lower alkyl.

14. The process of claim 1 wherein Z is selected from the group consisting of a moiety with the following structure 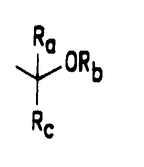 wherein Rₐ and R_{c} are selected from the group consisting of hydrogen and lower alkyl moieties wherein the number of carbon atoms is five or less, and R_{b} is a lower alkyl moiety, a dihydropyran derivative with the structure: 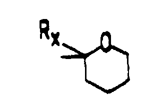 wherein Rₓ is selected from the group consisting of hydrogen and lower alkyl moieties, and a dihydrofuran derivative with the structure: 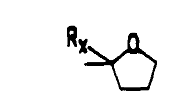 wherein Rₓ is a lower alkyl moiety.

15. The process of claim 14 wherein R_{b} is t-butyl.

16. The process of claim 14 further comprising baking the exposed resist at a temperature of about 90°C to about 130°C for at least about 30 seconds.
